Europäisches Patentamt

European Patent Office

Office européen des brevets

(19)

(11) **EP 1 158 494 B1**

(12) **EUROPEAN PATENT SPECIFICATION**

(45) Date of publication and mention
of the grant of the patent:
**29.05.2002 Bulletin 2002/22**

(51) Int Cl.[7]: **G10L 19/02**, G10H 1/00

(21) Application number: **00310934.5**

(22) Date of filing: **08.12.2000**

(54) **Method and apparatus for performing audio coding and decoding by interleaving smoothed critical band evelopes at higher frequencies**

Verfahren und Vorrichtung zur Audiokodierung und -dekodierung mittels Verschachtelung geglätteter Hüllkurven kritischer Bänder höherer Frequenzen

Procédé et dispositif de codage et décodage audio par entrelacement d'enveloppes lissées de bandes critiques de fréquences élevées

(84) Designated Contracting States:
**DE FR GB**
Designated Extension States:
**AL LT LV MK RO SI**

(30) Priority: **26.05.2000 US 580215**

(43) Date of publication of application:
**28.11.2001 Bulletin 2001/48**

(73) Proprietor: **LUCENT TECHNOLOGIES INC.**
**Murray Hill, New Jersey 07974-0636 (US)**

(72) Inventor: **Ghitza, Oded**
**Westfield, New Jersey, 07090 (US)**

(74) Representative:
**Watts, Christopher Malcolm Kelway, Dr.**
**Lucent Technologies (UK) Ltd,**
**5 Mornington Road**
**Woodford Green Essex, IG8 0TU (GB)**

(56) References cited:
**WO-A-99/16050**

- **LEFEBVRE R ET AL: "HIGH QUALITY CODING OF WIDEBAND AUDIO SIGNALS USING TRANSFORM CODEDEXCITATION (TCX)" PROCEEDINGS OF THE INTERNATIONAL CONFERENCE ON ACOUSTICS, SPEECH, ANDSIGNAL PROCESSING. (ICASSP),US,NEW YORK, IEEE, 19 April 1994 (1994-04-19), pages I-193-I-196, XP000529385 ISBN: 0-7803-1775-9**
- **RAMPRASHAD S A: "A TWO STAGE HYBRID EMBEDDED SPEECH/AUDIO CODING STRUCTURE" SEATTLE, WA, MAY 12 - 15, 1998,NEW YORK, NY: IEEE,US, vol. CONF. 23, 12 May 1998 (1998-05-12), pages 337-340, XP000854584 ISBN: 0-7803-4429-4**
- **WOLF ET AL: "source coding for multiple descriptions" BELL SYSTEM TECHNICAL JOURNAL, vol. 59, no. 8, October 1980 (1980-10), pages 1417-1426, XP001011314**

**Description**

**Field of the Invention**

The present invention relates generally to the field of audio coding systems, and more particularly to a method and apparatus for performing audio coding and decoding with increased efficiency based on the properties of the human auditory system.

**Background of the Invention**

The task of audio coding for use in coding signals representative of, for example, speech, music, *etc.,* which are typically employed for purposes of either storage or transmission of the audio signal, has received continual attention over the years in an attempt to minimize the number of bits required to code a given input signal while maintaining the quality of the resultant signal as reconstructed by a corresponding decoder. In the case of narrow-band speech, for example, where the speech signal has a bandwidth of, say, 4 kHz, the most effective speech coders have been based on Code Excited Linear Predictive (CELP) techniques, familiar to those of ordinary skill in the art. Coders which employ such CELP techniques typically operate in the 4-16 kb/s range. However, as a result of the inherent assumptions made about the source (*i.e*., the input speech signal), these coders typically perform quite poorly with music-like audio signals, for example.

On the other hand, audio coders which employ perceptual criteria, such as the Perceptual Audio Coder (PAC) described, for example, in "The Perceptual Audio Coder (PAC)" by D. Sinha *et al.,* in *The Digital Signal Processing Handbook* (V. Madisetti and D. Williams, eds.), pp. 42-1:42-17, CRC Press, 1998, work quite well at higher bit rates with wider bandwidth audio signals. Perceptual audio coders such as PAC are also well known to those of ordinary skill in the art. *(See also, e.g.,* U.S. Patent No. 5,040,217, "Perceptual Coding of Audio Signals," issued to K. Brandenburg *et al.* on August 13, 1991, and assigned to the assignee of the present invention. In particular, these perceptual audio coders achieve improved performance by quantizing a set of spectral *(i.e.,* frequency domain) coefficients with use of a psychoacoustic model *(i.e., a* model based on the performance of the human auditory system), thereby avoiding the "wasting" of coding bits which would otherwise be used to achieve a level of quantization accuracy which would not ultimately be distinguishable by the listener. Unfortunately, however, at bit rates below approximately 24 kb/s, coders such as PAC do not usually work well for speech-like audio signals.

More recently, hybrid coders, such as the Multimode Transform Predictive Coder (MTPC) described, for example, in "A Multimode Transform Predictive Coder (MTPC) for Speech and Audio" by S. Ramprashad, IEEE Speech Coding Workshop, pp. 10-12, 1999, attempt to combine both of these coding paradigms, and work reasonable well at ranges between 16 and 24 kb/s for both speech and audio signals. However, the complexity of such hybrid systems often become necessarily large, since they must essentially combine two diverse techniques into a single coder.

Another problem that invariably occurs with audio coders when the coded audio signals are transmitted over a packet switched network involves the issue of packet loss -- clearly, for such applications, all of these coders need to be fairly robust against packet losses in order to provide a useful tool in such environments. Although known error mitigation techniques, fully familiar to those of ordinary skill in the art, are reasonably effective, most such techniques tend to lose their efficiency at packet loss rates above about 3%. More particularly, the traditional approach to error mitigation in a packet switched network includes providing a relatively large receive buffer, which thereby reduces the impact of late arriving packets. However, when used in a two-way communications application, the increased delay will substantially impair the effectiveness of the two-way communication, and will also require more sophisticated echo control than would otherwise be required.

For this reason among others, multi-descriptive coding techniques, familiar to those of ordinary skill in the art and described, for example, in "Source Coding for Multiple Descriptions" by K. Wolf *et al.*, Bell System Technical Journal, vol. 59, no. 9, pp.1417-1426, 1980, have been suggested as a solution to this problem. Specifically, such techniques allow a source coder to split its information into two or more essentially equally relevant bit streams. For a two stream scenario, for example, each stream may be encoded such that when used independently by the decoder, it provides a reasonable quality level, but when both streams are used, the decoder provides a quality level which is better than the quality level achieved with use of a single stream. Assuming that both streams can be transmitted in a manner such that the packet loss probabilities are independent, much higher loss rates become tolerable with only a small degradation in quality.

Unfortunately, in general, it has proven in practice to be quite difficult to design an audio coder with multi-descriptive properties, without losing coding efficiency. One successful approach has involved the coding of a two channel stereo source (*e.g.,* stereo music) signal, where the inherent multi-descriptive property of the source (*i.e.,* the two independent channels) can be advantageously employed to provide the independent bit streams.

For the above reasons, it would be desirable to produce an audio coding system which adequately addresses both of these issues. In particular, it would be advantageous to provide a single source coder/decoder system which works well for both speech signals at low bit rates *and* for music signals at higher bit rates, without incurring the complexity of a hybrid approach. Moreover, it would be advantageous if such a source coding system provided a natural multi-descriptive decomposition of the signal for purposes of error mitigation when used in a packet switched environment.

## Summary of the Invention

In accordance with the principles of the present invention, it has been recognized that certain properties of the human auditory system may be advantageously employed to produce a single, non-hybrid audio coding system which works well for both speech and music signals, and that furthermore leads to a natural multi-descriptive decomposition. More specifically, it has been recognized that, at higher frequencies, the human auditory system loses synchrony to the underlying acoustic waveform stimulus being provided to it, and that temporal information for these frequencies is carried only by the instantaneous average rate of the neural firings of the auditory nerve.

Based on this recognition, in accordance with the present invention, the source signal to be coded is advantageously divided into a plurality of frequency bands, and, for frequencies below a given threshold frequency value, the waveform is coded so as to preserve the phase information thereof, whereas for those frequencies above the threshold value, the waveform of each of these (higher) frequency bands is decomposed into a carrier signal and an envelope signal, with only the envelope signal (but not the phase information of the carrier signal) being advantageously coded. Then, at the decoder, these coded envelope signals are decoded and used to modulate corresponding carrier waveforms, which may, for example, be fixed cosine carriers with frequencies which illustratively correspond to the frequency bands' center frequencies. In accordance with one illustrative embodiment of the present invention, the envelope signals may also be advantageously smoothed *(i.e.,* low-pass filtered) prior to coding.

More specifically, the present invention comprises a method and apparatus for coding an audio source signal, comprising steps or means for (a) dividing the audio signal into a plurality of frequency band signals, one or more of said frequency band signals being low frequency band signals which comprise frequency components below a given threshold frequency, and one or more of said frequency band signals being high frequency band signals which comprise frequency components above the given threshold frequency; (b) coding at least one of said low frequency band signals so as to preserve at least some of the phase information comprised in a waveform representative of said low frequency band signal; (c) generating, for at least one of said high frequency band signals, a corresponding critical band envelope signal which is representative of at least a portion of an envelope of a waveform representative of said corresponding high frequency band signal but which substantially excludes phase information associated with said waveform representative of said corresponding high frequency band signal; and (d) coding said at least one of said high frequency band signals by encoding said critical band envelope signals corresponding thereto.

Correspondingly, the present invention also comprises a method and apparatus for decoding an audio source signal so coded, comprising steps or means for (i) decoding each of said coded low frequency band signals to generate a corresponding reconstructed waveform representative of said corresponding low frequency band signal; (ii) decoding each of said coded high frequency band signals to generate a corresponding reconstructed critical band envelope signal corresponding to said corresponding high frequency band signal; (iii) combining each of said reconstructed critical band envelope signals with a corresponding carrier waveform to generate a corresponding reconstructed waveform representative of said high frequency band signal corresponding thereto; and (iv) combining each of said reconstructed waveforms representative of said corresponding low frequency band signals and said reconstructed waveforms representative of said corresponding high frequency band signals to generate a reconstructed waveform representative of the audio signal which has been encoded.

In addition, and in accordance with one illustrative embodiment of the present invention, two independent bit streams may be advantageously produced by the coder of the present invention -- one which is representative of a proper subset of the frequency bands above the threshold value, and the other which is representative of other frequency bands excluded from the proper subset. (The coded frequency band(s) below the threshold value may be advantageously included in both bit streams.) For example, these two subsets of frequency bands may be advantageously defined by interleaving alternating bands from the sequence of frequency bands above the threshold (such as, for example, by interleaving alternate "even" and "odd" subbands to produce an "even" channel and an "odd" channel). The two independent bit streams so created may then be advantageously coded in an otherwise conventional multi-descriptive manner, ultimately resulting in a two channel reconstructed signal which is produced by the corresponding illustrative decoder, and which may then be "played back" as a left channel and a right channel, respectively *(i.e.,* a stereo signal), thereby taking advantage of the binaural properties of the human auditory system.

**Brief Description of the Drawings**

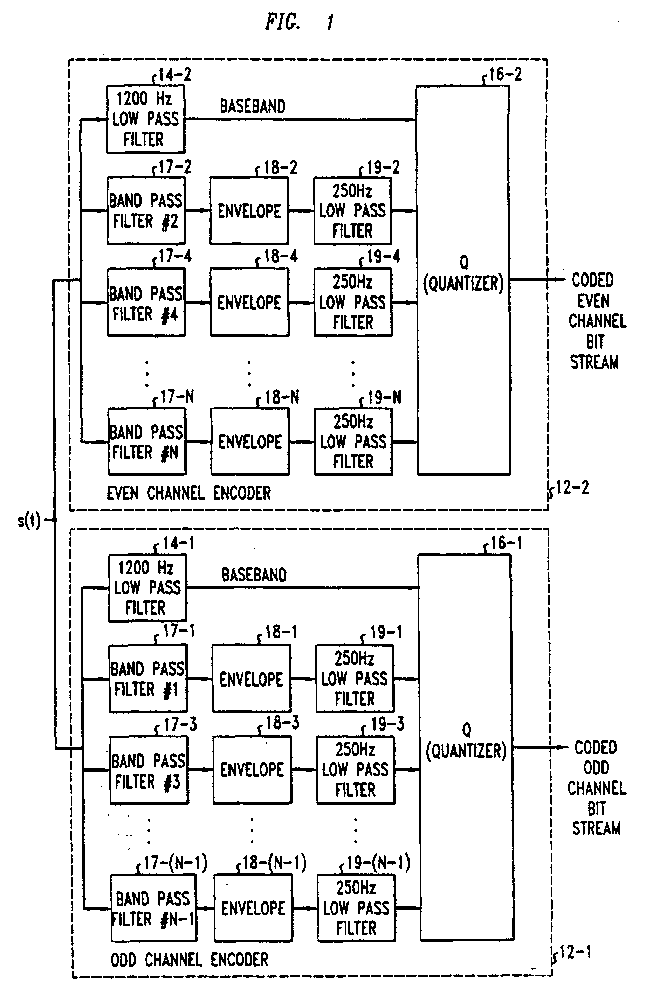

Fig. 1 shows an illustrative embodiment of an audio coder for use in a system for performing multi-descriptive stereophonic audio coding and decoding with use of smoothed and interleaved critical band envelopes at higher frequencies, in accordance with the techniques of the present invention.

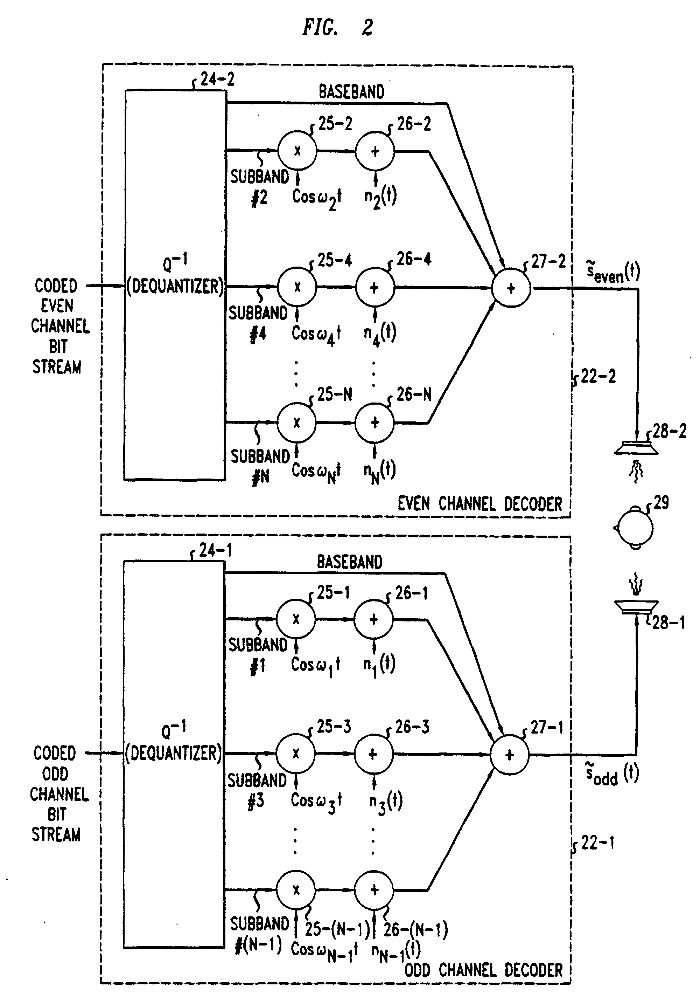

Fig. 2 shows an illustrative embodiment of a decoder corresponding to the audio coder of Fig. 1, for use in a system for performing multi-descriptive stereophonic audio coding and decoding with use of smoothed and interleaved critical band envelopes at higher frequencies, in accordance with the techniques of the present invention.

**Detailed Description**

**Introduction and mathematical analysis**

It is widely accepted that a decomposition of the output of a cochlear filter into a temporal envelope and a "carrier" may be used to quantify the role of auditory mechanisms in speech perception. *(See, e.g.,* "Parametric Coding of Speech Spectra," J. L. Flanagan, Journal of the Acoustical Society of America, vol. 68, no. 2, pp. 414-430, 1980.) This is supported by our current understanding of the way the auditory system (the periphery, in particular) operates.

By analogy between measured auditory nerve (AN) responses of the cat *(see, e.g.,* "Speech Coding in the Auditory Nerve: I. Vowel-like Sounds," B. Delgutte *et al.,* Journal of the Acoustical Society of America, vol. 75, no. 3, pp. 866-878, 1984) and possible AN responses of a human, we expect a significant difference between the properties of the firing patterns of low CF and high CF fibers. (As is familiar to those of ordinary skill in the art, CF, for Characteristic Frequency, indicates the place of origin of a nerve fiber along the basilar membrane in frequency units.) At low CFs, neural discharges of AN fibers are phase locked to the underlying driving cochlear signal *(i.e.,* synchrony is maintained). At high CFs, the synchrony of neural discharges is greatly reduced. In fact, at these CFs, temporal information is preserved by the instantaneous average rate of the neural firings, which is related to the temporal *envelope* of the underlying driving cochlear signal. Obviously, there is no distinct boundary between these AN regions. Rather, the change in properties is gradual. However, in accordance with one illustrative embodiment of the present invention, we have advantageously adopted a working hypothesis that the region of transition is at approximately 1200 Hz.

Therefore, in accordance with an illustrative embodiment of the present invention, for frequency bands above 1200 Hz, we advantageously take advantage of the physiological limitations of the Inner Hair Cell (IHC) to follow the carrier information (as reflected by the loss of synchrony in the AN neural firings). Mathematically, let:

$$s_i(t) = s(t) * h_i(t) = a_i(t)\cos\phi_i(t) \qquad (1)$$

where $s(t)$ is the input signal, $h_i(t)$ is the impulse response of cochlear filter $i$ which is centered at frequency $T_i > 1200$ Hz, the operator * represents convolution, and $a_i(t)$ and $\cos N_i(t)$ are the envelope and the carrier information of the cochlear signal $s_i(t),$ respectively. Note that because of the IHC limitations described above, neural firings of AN nerve fibers originating at $T_i$ exhibit only the envelope information $a_i(t)$, while the carrier information is lost. Now consider the following synthesized signal:

$$\hat{s}_i(t) = a_i(t)\cos\omega_i t \qquad (2)$$

That is, the original carrier $\cos N_i(t)$ has been advantageously replaced by a fixed cosine carrier, $\cos T_i(t)$. For a band-limited envelope $a_i(t)$, therefore, $\hat{s}_i(t)$ is a band-limited signal centered at frequency $T_i$. If $\hat{s}_i(t)$ is presented to the listener's ear, the resulting envelope signal at the appropriate place along the cochlear partition, which corresponds to frequency $T_i$, will be $a_i(t)$. Now let:

$$\hat{s}(t) = \sum_{i=1}^{N} \hat{s}_i(t) = \sum_{i=1}^{N} a_i(t)\cos\omega_i t \qquad (3)$$

where $a_i(t)$, $i = 1,..., N$ are the envelope signals of $N$ cochlear filters, equally spaced along the portion of the critical-band scale above 1200 Hz, with a spacing of one critical band. (As would be known to those skilled in the art, for an input signal with a bandwidth of 4 kHz, the number of critical bands above 1200 Hz is $N = 10$, and for an input signal with a bandwidth of 8 kHz, the corresponding value is $N = 17$.) Recalling that information is conveyed to the AN by a large, finite, number of highly overlapped cochlear filters (determined by the discrete distribution of the IHCs along the continuous cochlear partition), the overall envelope information at the AN level for the original signal $s(t)$ is represented with a frequency resolution determined by the density of the IHCs. However, in accordance with Eq. (3), the envelope signals $a_i(t)$, $i = 1,..., N$ which comprise reconstructed signal $\hat{s}(t)$ advantageously represent only a sparse sample of the overall envelope information at the AN level.

Now let $\hat{s}(t)$ of Eq. (3) be presented to the listener's ear. The envelope at the output of the listener's cochlear filter located at frequency $T_i$ is (ideally) $a_i(t)$, for each $i$, $i = 1,..., N$. Note, however, that the output of a cochlear filter located in between two successive cosine carrier frequencies, $T_i$ and $T_{i+1}$, will reflect "beating" of the two modulated cosine carrier signals passing through the filter. This may result in an undesired distortion.

Therefore, in accordance with one illustrative embodiment of the present invention, in order to reduce the potential of distortion due to beating, a dichotic synthesis (*i.e.*, where the signals presented to the left and right ears are different) with interleaving critical bands is advantageously employed. In particular, let $\hat{s}_{odd}(t)$ and $\hat{s}_{even}(t)$ be the summation of the odd components and even components of $\hat{s}(t)$, respectively. That is,

$$\hat{s}_{odd}(t) = \sum_{i \in odd}^{N-1} a_i(t) \cos \omega_i t \qquad (4)$$

and

$$\hat{s}_{even}(t) = \sum_{i \in even}^{N} a_i(t) \cos \omega_i t \qquad (5)$$

(It is assumed herein that $N$ is even.) The distance between two successive cosine carriers in each of these signals is larger, thereby advantageously resulting in a reduction of distortion due to carrier beating. When $\hat{s}_{odd}(t)$ and $\hat{s}_{even}(t)$, are presented to the left and the right ears, respectively, the auditory system will advantageously produce a single fused image.

Two points are noteworthy. First, note that $h_i(t)$ of Eq. (1) is a *cochlear* filter, which may, for example, be advantageously realized as a Gamma-tone filter, familiar to those of ordinary skill in the art. *(See, e.g.,* "Gamma-Tone Filters, Roex Filters, and Auditory Models" by B. Gold *et al.,* in *Speech and Audio Signal Processing,* section 19.4, pp. 264-266, John Wiley & Sons, 2000.) This implies that

$$h(t) = \sum_{i=1}^{N} h_i(t)$$

is *not* an all-pass filter. That is, the signal

$$\sum_{i=1}^{N} s_i(t)$$

, where $s_i(t)$ are the untampered cochlear signals of Eq. (1), is, in fact, different from the original signal $s(t)$ of Eq. (1). (Note on the other hand, however, as is well known to those of ordinary skill in the art, the filter bank in traditional sub-band coding systems is typically designed with a "perfect reconstruction" requirement.) Such a difference is not disadvantageous, however, because in accordance with the principles of the present invention, we do not aim to reproduce the original signal -- rather, our purpose is to synthesize a signal that will stimulate a neural activity at the listener's AN which is in correspondence with the cochlear envelope information that would be actually generated by the original signal.

Second, note that the signal processing technique described herein *(i.e.,* the use of pure cosine carriers to place the sampled envelope signals at the appropriate place along the basilar membrane) may produce an inherent, yet undesired, distortion. This can be seen by understanding that when the original signal *s(t)* is passed through the highly overlapped, full resolution cochlear filter-bank, the resulting envelope information gradually evolves as we move across the filter-bank array. In contrast, passing $s_{odd}(t)$ or $s_{even}(t)$ of Eqs. (4) and (5), respectively, through the same filter-bank, will advantageously result in a much coarser evolution of the envelope information because of the sparse sampling of the envelope information by the filters $h_i(t)$ of Eq. (1).

As described above, one source of information reduction which is obtained in accordance with the principles of the present invention is based on the IHCs physiological limitations in following the carrier information. This advantageously allows the usage of pure cosine carriers as shown, for example, in Eqs. (4) and (5). Of course the frequencies of the cosine carriers used by the coder are advantageously known to the receiver for use in decoding the received encoded signal. However, further information reduction may be advantageously achieved by replacing the cochlear envelope $a_i(t)$ in the above analysis with a *smoothed* envelope $\tilde{a}_i(t)$. This smoothing may be achieved in a conventional manner, with use of, for example, a low-pass filter. Then, Eqs. (4) and (5) become, respectively,

$$\tilde{s}_{odd}(t) = \sum_{i \in odd}^{N-1} \tilde{a}_i(t)\cos\omega_i t \qquad (6)$$

and

$$\tilde{s}_{even}(t) = \sum_{i \in even}^{N} \tilde{a}_i(t)\cos\omega_i t \qquad (7)$$

Psychophysical experiments have shown that if the cutoff frequency of the low-pass filter is approximately 250 Hz, a speech signal synthesized with the smoothed cochlear envelopes of Eqs. (6) and (7) is perceptually indistinguishable from the speech signal synthesized with the original envelopes of Eqs. (4) and (5). Thus, in accordance with an illustrative embodiment of the present invention, low-pass filters having a cutoff frequency of approximately 250 Hz are advantageously so employed to produce smoothed and interleaved critical band envelopes for coding at frequencies above 1200 Hz. These coded envelopes may then be decoded at the receiver as described above, and a corresponding pair of signals may be advantageously synthesized in accordance with Eqs. (6) and (7).

Note that by using dichotic synthesis with interleaving channels, the signals $\tilde{s}_{odd}(t)$ and $\tilde{s}_{even}(t)$ as synthesized in accordance with Eqs. (6) and (7) are uncorrelated above 1200 Hz. Hence, in accordance with various illustrative embodiments of the present invention, any of a number of multi-descriptive synthesis approaches may be advantageously employed. Illustratively, at the receiver (depending, for example, on the measured channel losses), the left ear (L) and the right ear (R) may be alternatively fed as either:

$$(1)\ \tilde{s}_{odd}(t)\ \text{to L and}\ \tilde{s}_{even}(t)\ \text{to R;}$$

$$(2)\ \tilde{s}_{odd}(t)\ \text{to both L and R; or}$$

$$(3)\ \tilde{s}_{even}(t)\ \text{to both L and R.}$$

Note that the approach of the present invention may, in certain cases, introduce two types of artifacts. First, the usage of pure cosine carriers may cause perceivable distortions in $s_{odd}(t)$ and $s_{even}(t)$ of Eqs. (4) and (5), the amount of which may depend on the interaction between spectral contents and carrier frequencies, as well as the listener experience. Second, a dichotic presentation may create a spatial image that is different from one created by a diotic *(i.e.,* where the same signal is presented to both ears) presentation. When the illustrative method of the present invention is used in accordance with a multi-descriptive system approach, a switch from the dichotic to the diotic mode results in a switch in the spatial location of the image. This problem may be mitigated in real-world applications where the two-channel delivery is accomplished via two loudspeakers *(e.g.,* as in a desktop application), rather than with the use of stereophonic headphones.

**An illustrative embodiment**

Fig. 1 shows an illustrative embodiment of an audio coder for use in a system for performing multi-descriptive stereophonic audio coding and decoding with use of smoothed and interleaved critical band envelopes at higher frequencies, in accordance with the techniques of the present invention. Note in particular that the information to be transmitted from the coder to the decoder is comprised of the encoded baseband signal (*i.e.,* that portion of the signal comprising frequencies below 1200 Hz) and the encoded smoothed (*i.e.,* low-pass filtered) critical-band envelopes. Moreover, note that in accordance with the illustrative embodiment of the present invention as shown in the figure, two bit streams are generated -- one comprising the encoded representation of the "even" channels (in combination with the encoded representation of the baseband signal), and one comprising the encoded representation of the "odd" channels (also in combination with the encoded representation of the baseband signal).

Specifically, the illustrative coder of Fig. 1 comprises odd channel encoder 12-1 and even channel encoder 12-2, for generating a pair of coded bit streams -- *i.e.,* the coded even channel bit stream and the coded odd channel bit stream, respectively. The input signal, $s(t)$, which comprises the audio signal to be coded, is provided to both odd channel encoder 12-1 and even channel encoder 12-2, and is sent through a corresponding filterbank in each. For example, the filterbank of odd channel encoder 12-1 comprises 1200 Hz low pass filter 14-1 which produces the baseband signal (*i.e.,* the frequency components of the signal which are less than or equal to 1200 Hz), as well as band pass filters for all of the "odd-numbered" critical bands above 1200 Hz --namely, band pass filter 17-1 through band pass filter 17-($N$-1) as shown -- which produce subband signals corresponding to the given critical bands. Similarly, the filterbank of even channel encoder 12-2 comprises 1200 Hz low pass filter 14-2 which also produces the baseband signal, as well as band pass filters for all of the "even-numbered" critical bands above 1200 Hz -- namely, band pass filter 17-2 through band pass filter 17-$N$ as shown -- which also produce subband signals corresponding to the given critical bands. Each of the filters of these filterbanks are fully conventional and familiar to those of ordinary skill in the art. Advantageously, the set of band pass filters is equally distributed along the Bark scale, and each filter has a "cochlear" frequency response, such as, for example, that of a Gamma-tone filter, familiar to those of ordinary skill in the art. (As is also known to those skilled in the art, the Bark scale comprises an approximately logarithmic frequency scale representative of the actual bands of the cochlea.) Note that it is assumed herein for illustrative simplicity that $N$ -- the number of critical bands above 1200 Hz -- is an even number.

For each of the higher frequency subband signals (in both odd channel encoder 12-1 and even channel encoder 12-2), envelope generator 18-$i$ (corresponding to the subband signal produced by band pass filter 17-$i$) removes the carrier portion of the signal (namely, $\cos N_i(t)$ in accordance with the mathematical analysis described above), thereby leaving only the "envelope" portion $a_i(t)$ of the signal for coding, in accordance with the principles of the present invention. Then, for each of these produced "envelope" signals, 250 Hz low pass filters 19-$i$ (corresponding to the envelope signals produced by envelope generators 18-$i$) advantageously "smooth" the envelope signals (also in accordance with the mathematical analysis described above). Note that both the envelope generators and the 250 Hz low pass filters are conventional and will be fully familiar to those of ordinary skill in the art. Finally, quantizer 16-1 (in odd channel encoder 12-1) and quantizer 16-2 (in even channel encoder 12-2) use conventional quantization techniques (*see, e.g.,* the discussion of illustrative implementation considerations below), also fully familiar to those of ordinary skill in the art, to encode the baseband signal and the smoothed envelopes of the individual critical band signals to generate the corresponding coded bit stream.

Fig. 2 shows an illustrative embodiment of a decoder corresponding to the audio coder of Fig. 1, also for use in a system for performing multi-descriptive stereophonic audio coding and decoding with use of smoothed and interleaved critical band envelopes at higher frequencies, in accordance with the techniques of the present invention. Note again that the information which has been transmitted from the coder to the decoder is comprised of the encoded baseband signal (*i.e.,* that portion of the signal comprising frequencies below 1200 Hz) and the encoded smoothed (*i.e.,* low-pass filtered) critical-band envelopes. Moreover, note again that in accordance with the illustrative embodiment of the present invention as shown in the figure, two bit streams are received by the decoder -- one comprising the encoded representation of the "even-numbered" subbands (in combination with the encoded representation of the baseband signal), and one comprising the encoded representation of the "odd-numbered" subbands (also in combination with the encoded representation of the baseband signal).

Specifically, the illustrative decoder of Fig. 2 comprises odd channel decoder 22-1 and even channel decoder 22-2, for decoding the received pair of coded bit streams -- *i.e.,* the coded even channel bit stream and the coded odd channel bit stream, respectively. First, dequantizer 24-1 (in odd channel decoder 22-1) and dequantizer 24-2 (in even channel decoder 22-2) decode the bit streams to produce the individual signals -- the baseband signal (in each of the odd channel decoder and the even channel decoder) and the included set of smoothed critical band envelope signals. In particular, dequantizer 24-1 of odd channel decoder 22-1 generates the baseband signal as well as the smoothed critical band envelope signals for each of the odd-numbered subbands, while dequantizer 24-2 of even channel decoder 22-2 also generates the baseband signal, but generates as well the smoothed critical band envelope signals for each of the even-numbered subbands. Dequantizers 24-1 and 24-2, which correspond in functionality to (*i.e.,* perform the inverse function of) quantizers 16-1 and 16-2 of odd channel encoder 12-1 and even channel encoder 12-2, respectively, as shown in Fig. 1, are also fully conventional and familiar to those of ordinary skill in the art.

Next, for each of the smoothed critical band envelope signals, each of odd channel decoder 22-1 and even channel decoder 22-2 comprise multiplier circuits 25-i (corresponding to and processing the regenerated smoothed critical band envelope signals for subband *i*), which multiply the corresponding smoothed critical band envelope signal by a fixed cosine carrier -- namely, cos $T_i(t)$, where $T$ is advantageously chosen to be the center frequency of critical band $_i$. In this manner, the resultant synthesized signal comprises a fixed cosine carrier signal centered on the given critical band which is modulated by the decoded version of the coded and transmitted smoothed critical band envelope signal corresponding to the given critical band. (See the mathematical analysis presented above, and, in particular, Eq. (2) and the discussion thereof.)

Next, for each of the reconstructed critical band signals as produced by corresponding multiplier circuit 25-*i*, corresponding adder circuit 26-*i* advantageously adds a corresponding low-intensity band-limited noise signal, $n_i(t)$, which achieves a reduction in artificial noise in the reconstructed signal by "filling in" the adjacent unoccupied frequency bands with low-level noise, such as, for example, white Gaussian noise, familiar to those of ordinary skill in the art. In particular, the signal-to-noise ratio of the noise signal with respect to the intensity of the actual signal in the occupied band (to which the noise signal is being added) may advantageously be about -10 dB, and the bandwidth of the noise signal may advantageously cover three successive frequency bands (centered at the frequency band to which the noise is being added). Such low-intensity noise signals are conventional and will be easily definable by those skilled in the art. Note that this noise signal may also advantageously have a cochlear-like shape.

Finally, adder circuit 27-1 of odd channel decoder 22-1 sums the decoded baseband signal together with each of the synthesized subband signals for the odd-numbered subbands (as generated by adder circuits 26-1, 26-3, ..., 26-(*N*-1)) to generate the resultant synthesized signal $\tilde{s}_{odd}(t)$, as described above. (See, *e.g.,* Eq. (6).) Similarly, adder circuit 27-2 of even channel decoder 22-2 sums the decoded baseband signal together with each of the synthesized subband signals for the even-numbered subbands (as generated by adder circuits 26-2, 26-4,..., 26-*N*) to generate the resultant synthesized signal $\tilde{s}_{even}(t)$, as described above. (See, *e.g.,* Eq. (7).) Thus, in accordance with the principles of the present invention and as further illustratively shown in the figure, $\tilde{s}_{odd}(t)$ may be provided to loudspeaker 28-1, and $\tilde{s}_{even}(t)$ may be provided to loudspeaker 28-2 (or, in other illustrative embodiments, vice versa), thereby advantageously feeding the left ear of listener 29 with the acoustic reproduction of signal $\tilde{s}_{odd}(t)$, and his or her right ear with the acoustic reproduction of signal $\tilde{s}_{even}(t)$, as also described above.

### Additional illustrative implementation considerations

In accordance with an illustrative embodiment of the present invention, the overall complexity and delay of a coding system based on the techniques as employed in the present invention may be advantageously constrained as described herein. Note that additional techniques which will be familiar to those skilled in the art may also be employed to obtain better coding efficiency, albeit in some cases at the expense of an increase in delay.

Illustratively, the bandpass filter-bank of Fig. 1 may be implemented with 128 tap FIR (finite-impulse-response) filters, fully familiar to those of ordinary skill in the art, thereby introducing an 8 ms delay (*i.e.,* at 8000 samples/sec). The baseband signal (having a 1200 Hz bandwidth) and the low-pass filtered envelope signals (having a 250 Hz bandwidth) may be advantageously down-sampled by ratios of 1/3 (*i.e..* to 2666 samples/sec) and 1/15 (*i.e.,* to 533 samples/sec), respectively, to maintain a straightforward time relationship between the various signals. (Such down-sampling is not shown in the illustrative figures provided herein, but would be fully familiar to those of ordinary skill in the art.) Any coding delay at the down-sampled frequencies will increase delay by its respective down-sampling factor. Therefore, in accordance with the illustrative embodiment described herein, coding schemes that work on a sample-by-sample basis may be advantageously employed. For example, coding techniques such as Delta-Modulation or ADPCM, both fully familiar to those of ordinary skill in the art, may be advantageously used.

It has been determined that the down-sampled envelope signals as described herein are quite robust against quantization noise, and therefore, a simple ADPCM approach with a 2 bits/sample quantizer may be advantageously used. In contrast, the baseband signal has been determined to be more sensitive to quantization errors. Using ADPCM, it has in particular been determined that 3 bits/sample provides for an acceptable quality level. Although, in accordance with other illustrative embodiments of the present invention, the baseband portion of the coder may be used to implement a multi-descriptive coding scheme, for purposes of simplicity and efficiency, in accordance with the illustrative embodiment of the present invention being specifically described herein, the baseband information is used in its totality in both streams. Thus, by way of example, the total bit rate of the described embodiment is illustratively:

2 channels x (baseband: 8 kb/s + envelopes: 5 x 1.066 kb/s) = 26.66 kb/s,

and the approximate total coding complexity is illustratively:

(baseband: 1.3 MIPS + envelopes: 10 x 0.3 MIPS) = 4.3 MIPS.

Backward adaptive prediction, familiar to those of ordinary skill in the art, with a limited size VQ (Vector Quantizer, also familiar to those of ordinary skill in the art), can further advantageously reduce the number of bits per sample without introducing large algorithmic delays. Note that the predictor order need not be particularly high to produce an accurate description of the spectrum, as can be easily determined by those of ordinary skill in the art. The specific choice of down-sampling rates as described above in accordance with this illustrative embodiment of the present invention advantageously allows for the use of a 5 dimensional VQ without introducing additional coding delay. Further in accordance with the illustrative embodiment of the present invention, a modified version of LD-CELP (Low Delay Code Excited Linear Prediction, a coding technique fully familiar to those of ordinary skill in the art) may be advantageously employed, using a 16th order predictor on the down-sampled signal (without using post-filtering in the decoder), resulting in 2 bits/sample (*i.e.*, 2666 samples/sec) without a noticeable audible degradation and with a complexity of 8 MIPS.

At the decoder, the signals may be advantageously up-sampled and interpolated with 32-tap FIR (finite-impulse-response) filters, fully familiar to those of ordinary skill in the art, resulting in an additional 2 ms delay. The overall complexity of this approach is approximately 14 MIPS for the filtering and up-sampling, and approximately 11 MIPS for the quantization. The total end-to-end delay is 10 ms due to filtering and 2 ms due to coding. The total bit rate is illustratively:

2 channels x (baseband: 5.33 kb/s + envelopes: 5 x 1.066 kb/s) = 21.332 kb/s.

And finally, note that for wide-band signals (8 kHz), the net increase in bit rate will advantageously be only 3 to 4 kb/s for each bit stream.

**Addendum to the detailed description**

The preceding merely illustrates the principles of the invention. It will thus be appreciated that those skilled in the art will be able to devise various arrangements which, although not explicitly described or shown herein, embody the principles of the invention and are included within the scope of the invention as defined by the appended claims. Furthermore, all examples and conditional language recited herein are principally intended expressly to be only for pedagogical purposes to aid the reader in understanding the principles of the invention and the concepts contributed by the inventors to furthering the art, and are to be construed as being without limitation to such specifically recited examples and conditions. Moreover, all statements herein reciting principles, aspects, and embodiments of the invention, as well as specific examples thereof, are intended to encompass both structural and functional equivalents thereof. Additionally, it is intended that such equivalents include both currently known equivalents as well as equivalents developed in the future -- *i.e.*, any elements developed that perform the same function, regardless of structure.

Thus, for example, it will be appreciated by those skilled in the art that the block diagrams herein represent conceptual views of illustrative circuitry embodying the principles of the invention. Similarly, it will be appreciated that any flow charts, flow diagrams, state transition diagrams, pseudocode, and the like represent various processes which may be substantially represented in computer readable medium and so executed by a computer or processor, whether or not such computer or processor is explicitly shown.

The functions of the various elements shown in the figures, including functional blocks labeled as "processors" or "modules" may be provided through the use of dedicated hardware as well as hardware capable of executing software in association with appropriate software. When provided by a processor, the functions may be provided by a single dedicated processor, by a single shared processor, or by a plurality of individual processors, some of which may be shared. Moreover, explicit use of the term "processor" or "controller" should not be construed to refer exclusively to hardware capable of executing software, and may implicitly include, without limitation, digital signal processor (DSP) hardware, read-only memory (ROM) for storing software, random access memory (RAM), and non-volatile storage. Other hardware, conventional and/or custom, may also be included. Similarly, any switches shown in the Figs. are conceptual only. Their function may be carried out through the operation of program logic, through dedicated logic, through the interaction of program control and dedicated logic, or even manually, the particular technique being selectable by the implementor as more specifically understood from the context.

In the claims hereof any element expressed as a means for performing a specified function is intended to encompass any way of performing that function including, for example, (a) a combination of circuit elements which performs that function or (b) software in any form, including, therefore, firmware, microcode or the like, combined with appropriate circuitry for executing that software to perform the function.

**Claims**

1. A method of coding an audio signal comprising the steps of:

   (a) dividing the audio signal into a plurality of frequency band signals, one or more of said frequency band signals being low frequency band signals which comprise frequency components below a given threshold frequency, and one or more of said frequency band signals being high frequency band signals which comprise frequency components above the given threshold frequency;
   (b) coding at least one of said low frequency band signals so as to preserve at least some of the phase information comprised in a waveform representative of said low frequency band signal;
   (c) generating, for at least one of said high frequency band signals, a corresponding critical band envelope signal which is representative of at least a portion of an envelope of a waveform representative of said corresponding high frequency band signal but which excludes phase information associated with said waveform representative of said corresponding high frequency band signal; and
   (d) coding said at least one of said high frequency band signals by encoding said critical band envelope signals corresponding thereto.

2. The method of claim 1 wherein said step of dividing the audio signal into a plurality of frequency band signals is performed with use of one or more Gamma-tone filters.

3. The method of claim 1 further comprising the step of low-pass filtering each of said critical band envelope signals, wherein said step of coding said at least one of said high frequency band signals comprises encoding said filtered critical band envelope signals corresponding thereto.

4. The method of claim 3 wherein said step of low-pass filtering said critical band envelope signals is performed with use of approximately 250 Hz low-pass filters.

5. The method of claim 1 further comprising the step of generating a first coded bit stream comprising a first proper subset of said coded high frequency band signals and a second bit stream comprising a second proper subset of said coded high frequency band signals, said first and second proper subsets being disjoint and together comprising all of said high frequency band signals.

6. The method of claim 5 wherein said first and second proper subsets comprise alternating high frequency band signals when said high frequency band signals are ordered by increasing frequency.

7. A method of decoding an audio signal which has been encoded by performing the steps of (a) dividing the audio signal into a plurality of frequency band signals, one or more of said frequency band signals being low frequency band signals which comprise frequency components below a given threshold frequency, and one or more of said frequency band signals being high frequency band signals which comprise frequency components above the given threshold frequency; (b) coding at least one of said low frequency band signals so as to preserve at least some of the phase information comprised in a waveform representative of said low frequency band signal; (c) generating, for at least one of said high frequency band signals, a corresponding critical band envelope signal which is representative of at least a portion of an envelope of a waveform representative of said corresponding high frequency band signal but which excludes phase information associated with said waveform representative of said waveform representative of said corresponding high frequency band signal; and (d) coding said at least one of said high frequency band signals by encoding said critical band envelope signals corresponding thereto, the method of decoding comprising the steps of:

   (i) decoding each of said coded low frequency band signals to generate a corresponding reconstructed waveform representative of said corresponding low frequency band signal;

(ii) decoding each of said coded high frequency band signals to generate a corresponding reconstructed critical band envelope signal corresponding to said corresponding high frequency band signal;

(iii) combining each of said reconstructed critical band envelope signals with a corresponding carrier waveform to generate a corresponding reconstructed waveform representative of said high frequency band signal corresponding thereto; and

(iv) combining each of said reconstructed waveforms representative of said corresponding low frequency band signals and each of said reconstructed waveforms representative of said corresponding high frequency band signals to generate a reconstructed waveform representative of the audio signal which has been encoded.

8.  The method of claim 7 wherein said encoding of the audio signal further comprised performing the step of generating a first coded bit stream comprising a first proper subset of said coded high frequency band signals and a second bit stream comprising a second proper subset of said coded high frequency band signals, said first and second proper subsets being disjoint and together comprising all of said high frequency band signals, and wherein said method of decoding is independently performed on each of said first coded bit stream and said second coded bit stream to thereby generate a first reconstructed waveform and a second reconstructed waveform, each reconstructed waveform being representative of the audio signal which has been encoded.

9.  The method of claim 7 wherein said step of combining said reconstructed critical band envelope signals with said corresponding carrier waveforms comprises modulating each of said carrier waveforms with said corresponding reconstructed critical band envelope signal.

10.  The method of claim 9 wherein each of said carrier waveforms comprises a cosine waveform of a corresponding fixed frequency.

11.  The method of claim 10 wherein said fixed frequency of said corresponding carrier waveform is approximately equal to a center frequency of the high frequency band signal which corresponds thereto.

12.  The method of claim 7 further comprising the step of combining each of said reconstructed waveforms representative of a corresponding high frequency band signal with a corresponding noise signal.

13.  The method of any of the preceding claims wherein the audio signal comprises a speech signal.

14.  The method of any of claims 1 to 12 wherein the audio signal - comprises a music signal.

15.  The method of any of the preceding claims wherein said one or more frequency bands are approximately equally distributed along a Bark scale.

16.  The method of any of the preceding claims wherein said given threshold frequency is approximately 1200 Hz.

17.  An apparatus comprising means arranged for carrying out the steps of a method as claimed in any of the preceding claims.

**Patentansprüche**

1.  Verfahren zum Codieren eines Tonsignals, mit den Verfahrensschritten:

    a) Zerlegen des Tonsignals in eine Vielzahl von Frequenzbandsignalen, wobei es sich bei einem oder mehreren dieser Frequenzbandsignale um Niederfrequenzbandsignale handelt, die Frequenzkomponenten unterhalb eines gegebenen Schwellenwertes der Frequenz enthalten, und wobei es sich bei einem oder mehreren der Frequenzbandsignale um Hochfrequenzbandsignale handelt, die Frequenzkomponenten oberhalb eines gegebenen Schwellenwertes der Frequenz enthalten;

    b) Codieren wenigstens eines der Niederfrequenzbandsignale derart, daß zumindest ein gewisser Teil der Phaseninformation gewahrt bleibt, die in einer für das Niederfrequenzbandsignal repräsentativen Wellenform enthalten ist;

    c) für wenigstens eines der Hochfrequenzbandsignale Erzeugen eines entsprechenden Hüllkurvensignals mit kritischem Band, das für wenigstens einen Bereich einer Einhüllenden einer Wellenform repräsentativ ist, die ihrerseits für das betreffende Hochfrequenzbandsignal repräsentativ ist, jedoch jegliche Phaseninformation, welche der für das entsprechende Hochfrequenzbandsignal repräsentativen Wellenform zugeordnet ist, ausschließt; und

d) Codieren wenigstens des einen Hochfrequenzbandsignals durch Codieren des diesem entsprechenden Hüllkurvensignals mit kritischem Band.

2. Verfahren nach Anspruch 1, wobei der Schritt des Zerlegens des Tonsignals in eine Vielzahl von Frequenzbandsignalen unter Verwendung eines oder mehrerer Gamma-Tonfilter durchgeführt wird.

3. Verfahren nach Anspruch 1 mit dem Schritt des Tiefpaßfilterns jedes Hüllkurvensignals mit kritischem Band, wobei der Schritt des Codierens des wenigstens einen Hochfrequenzbandsignals das Codieren des diesem Signal entsprechenden gefilterten Hüllkurvensignals mit kritischem Band umfaßt.

4. Verfahren nach Anspruch 3, wobei der Schritt des Tiefpaßfilterns des Hüllkurvensignals mit kritischem Band unter Verwendung von näherungsweise 250 Hz-Tiefpaßfiltern durchgeführt wird.

5. Verfahren nach Anspruch 1, das weiterhin den Schritt des Erzeugens eines ersten codierten Bitstroms, der eine erste echte Teilmenge der codierten Hochfrequenzbandsignale beinhaltet, und eines zweiten Bitstroms umfaßt, der eine zweite echte Teilmenge der codierten Hochfrequenzbandsignale beinhaltet, wobei die erste und zweite echte Teilmenge voneinander unabhängig sind und zusammen alle Hochfrequenzbandsignale enthalten.

6. Verfahren nach Anspruch 5, wobei die erste und zweite echte Teilmenge alternierende Hochfrequenzbandsignale umfassen, wenn die Hochfrequenzbandsignale nach ansteigender Frequenz geordnet sind.

7. Verfahren zum Decodieren eines Tonsignals, das durch Ausführen folgender Schritte codiert worden ist:

(a) Zerlegen des Tonsignals in eine Vielzahl von Frequenzbandsignalen, wobei es sich bei einem oder mehreren dieser Frequenzbandsignale um Niederfrequenzbandsignale handelt, die Frequenzkomponenten unterhalb eines gegebenen Schwellenwertes der Frequenz enthalten, und wobei es sich bei einem oder mehreren der Frequenzbandsignale um Hochfrequenzbandsignale handelt, die Frequenzkomponenten oberhalb des gegebenen Schwellenwertes der Frequenz enthalten; (b) Codieren wenigstens eines der Niederfrequenzbandsignale derart, daß zumindest ein gewisser Teil der Phaseninformation gewahrt bleibt, die in einer für das Niederfrequenzbandsignal repräsentativen Wellenform enthalten ist; (c) für wenigstens eines der Hochfrequenzbandsignale Erzeugen eines entsprechenden Hüllkurvensignals mit kritischem Band, das für wenigstens einen Bereich einer Einhüllenden einer Wellenform repräsentativ ist, die ihrerseits für das entsprechende Hochfrequenzbandsignal repräsentativ ist, welches jedoch jegliche Phaseninformation, die der für das entsprechende Hochfrequenzbandsignal repräsentativen Wellenform zugeordnet ist, ausschließt; und (d) Codieren dieses wenigstens einen Hochfrequenzbandsignale durch Codieren der diesem Signal entsprechenden Hüllkurvensignale mit kritischem Band, wobei das Verfahren zum Decodieren die Verfahrensschritte umfaßt:

I. Decodieren jedes der codierten Niederfrequenzbandsignale, um eine entsprechende wiederhergestellte Wellenform zu erzeugen, die für das entsprechende Niederfrequenzbandsignal repräsentativ ist;

II. Decodieren jedes der Hochfrequenzbandsignale, um ein entsprechendes wiederhergestelltes Hüllkurvensignal mit kritischem Band zu erzeugen, das dem entsprechenden Hochfrequenzbandsignal entspricht;

III. Verbinden jedes dieser wiederhergestellten Hüllkurvensignale mit kritischem Band mit einer entsprechenden Trägerwellenform, um eine entsprechende wiederhergestellte Wellenform zu erzeugen, die für das diesem Signal entsprechende Hochfrequenzbandsignal repräsentativ ist; und

IV. Verbinden jeder dieser wiederhergestellten Wellenformen, die für die entsprechenden Niederfrequenzbandsignale repräsentativ sind, und jeder der wiederhergestellten Wellenformen, die für die entsprechenden Hochfrequenzbandsignale repräsentativ sind, um eine wiederhergestellte Wellenform zu erzeugen, die für das Tonsignal repräsentativ ist, das codiert wurde.

8. Verfahren nach Anspruch 7, wobei das Codieren des Tonsignals weiterhin den Schritt des Erzeugens eines ersten codierten Bitstroms, der eine erste echte Teilmenge der codierten Hochfrequenzbandsignale enthält, und eines zweiten Bitstroms umfaßt, der eine zweite echte Teilmenge der codierten Hochfrequenzbandsignale enthält, wobei die erste und zweite echte Teilmenge voneinander unabhängig sind und zusammen alle Hochfrequenzbandsignale enthalten, und wobei das Verfahren des Decodierens unabhängig auf jedem ersten codierten Bitstrom und zweiten codierten Bitstrom ausgeführt wird, um dadurch eine erste wiederhergestellte Wellenform und eine zweite wiederhergestellte Wellenform zu erzeugen, wobei jede wiederhergestellte Wellenform repräsentativ für das Tonsignal ist, das codiert wurde.

**9.** Verfahren nach Anspruch 7, wobei der Schritt des Verbindens der wiederhergestellten Hüllkurvensignale mit kritischem Band mit den entsprechenden Trägerwellenformen das Modulieren jeder der Trägerwellenformen mit dem entsprechenden wiederhergestellten Hüllkurvensignal mit kritischem Band umfaßt.

**10.** Verfahren nach Anspruch 9, wobei jede der Trägerwellenformen eine Kosinus-Wellenform von enstprechender fester Frequenz enthält.

**11.** Verfahren nach Anspruch 10, wobei die feste Frequenz der entsprechenden Trägerwellenform näherungsweise gleich einer Mittenfrequenz des dementsprechenden Hochfrequenzbandsignals ist.

**12.** Verfahren nach Anspruch 7, das weiterhin den Schritt des Verbindens jeder der wiederhergestellten Wellenformen, die ein entsprechendes Hochfrequenzbandsignal darstellt, mit einem entsprechenden Rauschsignal umfaßt.

**13.** Verfahren nach einem der vorangegangenen Ansprüche, wobei das Tonsignal ein Sprachsignal umfaßt.

**14.** Verfahren nach einem der Ansprüche 1 bis 12, wobei das Tonsignal ein Musiksignal umfaßt.

**15.** Verfahren nach einem der vorangegangenen Ansprüche, wobei eines oder mehrere der Frequenzbandsignale näherungsweise gleichmäßig auf einer Barkskala verteilt sind.

**16.** Verfahren nach einem der vorangegangenen Ansprüche, wobei der besagte Schwellenwert der Frequenz näherungsweise 1200 Hz beträgt.

**17.** Vorrichtung, die eine Einrichtung zum Ausführen der Schritte eines Verfahrens nach einem der vorangegangenen Ansprüche umfaßt.


**Revendications**

**1.** Procédé de codage d'un signal audio, comprenant les étapes consistant à :

(a) diviser le signal audio en une pluralité de signaux en bandes de fréquences, un ou plusieurs de ces signaux en bandes de fréquences étant des signaux en bandes à basses fréquences qui comprennent des composantes de fréquences inférieures à une fréquence seuil donnée, et un ou plusieurs des signaux en bandes de fréquences étant des signaux en bandes à hautes fréquences qui comprennent des composantes de fréquence supérieures à la fréquence seuil donnée ;
(b) coder au moins l'un des signaux en bandes à basses fréquences de façon à préserver au moins certaines des informations de phase contenues dans une forme d'onde représentative du signal en bande à basses fréquences ;
(c) produire, pour au moins l'un des signaux en bandes à hautes fréquences, un signal d'enveloppe correspondant en bande critique qui est représentatif d'au moins une partie d'une enveloppe d'une forme d'onde représentative du signal correspondant en bande à hautes fréquences, mais qui exclut des informations de phase associées à la forme d'onde du signal en bande à haute fréquence correspondant ; et
(d) coder ledit au moins un des signaux en bandes à hautes fréquences, en codant les signaux d'enveloppe en bande critique qui leur correspondent.

**2.** Procédé suivant la revendication 1, dans lequel l'étape de division du signal audio en une pluralité de signaux en bandes de fréquences est effectuée par utilisation d'un ou plusieurs filtres à tonalité Gamma.

**3.** Procédé suivant la revendication 1, comprenant en outre l'étape consistant à soumettre à un filtrage passe-bas chacun des signaux d'enveloppe en bande critique, l'étape de codage dudit au moins un des signaux en bandes à hautes fréquences comprenant un codage des signaux d'enveloppe filtrés en bande critique qui leur correspondent.

**4.** Procédé suivant la revendication 3, dans lequel l'étape de filtrage passe-bas des signaux d'enveloppe en bande critique est effectuée par utilisation de filtres passe-bas d'environ 250 Hz.

**5.** Procédé suivant la revendication 1, comprenant en outre l'étape consistant à produire un premier train binaire codé comprenant un premier sous-ensemble propre des signaux codés en bande à hautes fréquences et un second train binaire comprenant un second sous-ensemble propre des signaux codés en bandes à hautes fréquences, les premier et second sous-ensembles propres étant disjoints et constituant ensemble la totalité des signaux en bandes à hautes fréquences.

**6.** Procédé suivant la revendication 5, dans lequel les premier et second sous-ensembles propres comprennent des signaux alternés en bandes à hautes fréquences, lorsque les signaux en bandes à hautes fréquences sont ordonnés par ordre de fréquence croissante.

**7.** Procédé de décodage d'un signal audio ayant été codé par exécution des étapes (a) de division du signal audio en une pluralité de signaux en bandes de fréquences, un ou plusieurs des signaux en bandes de fréquences étant des signaux en bandes à basses fréquences qui comprennent des composantes de fréquences inférieures à une fréquence seuil donnée, et un ou plusieurs des signaux en bandes de fréquences étant des signaux en bandes à hautes fréquences qui comprennent des composantes de fréquences supérieures à la fréquence seuil donnée ; (b) coder au moins l'un des signaux en bandes à basses fréquences de façon à préserver au moins certaines des informations de phase contenues dans une forme d'onde représentative du signal en bandes à basses fréquences ; (c) produire, pour au moins l'un des signaux en bandes à hautes fréquences, un signal d'enveloppe correspondant en bande critique qui est représentatif d'au moins une partie d'une enveloppe d'une forme d'onde représentative du signal correspondant en bande à hautes fréquences, mais qui exclut des informations de phase associées à cette forme d'onde représentative du signal correspondant en bande à hautes fréquences ; et (d) coder ledit au moins un des signaux en bandes à hautes fréquences, en codant les signaux d'enveloppe en bande critique qui leur correspondent, le procédé de décodage comprenant les étapes consistant à :

(i) décoder chacun des signaux codés en bandes à basses fréquences pour produire une forme d'onde reconstruite correspondante représentative du signal correspondant en bande à basses fréquences ;
(ii) décoder chacun des signaux codés en bandes à hautes fréquences pour produire un signal d'enveloppe correspondant reconstruit en bande critique correspondant au signal correspondant en bande à hautes fréquences ;
(iii) combiner chacun des signaux d'enveloppe reconstruits en bande critique avec une forme d'onde porteuse afin de produire une forme d'onde reconstruite correspondante représentative du signal en bande à hautes fréquences qui lui correspond ; et
(iv) combiner chacune des formes d'ondes reconstruites représentatives des signaux correspondants en bandes à basses fréquences et chacune des formes d'ondes reconstruites représentative des signaux correspondants en bandes à hautes fréquences pour produire une forme d'onde reconstruite représentative du signal audio ayant été codé.

**8.** Procédé suivant la revendication 7, dans lequel le codage du signal audio consiste en outre à effectuer l'étape consistant à produire un premier train binaire codé comprenant un premier sous-ensemble propre des signaux codés en bandes à hautes fréquences et un second train binaire comprenant un second sous-ensemble propre des signaux codés en bandes à hautes fréquences, lesdits premier et second sous-ensembles propres étant disjoints et constituant ensemble la totalité des signaux en bandes à hautes fréquences, et dans lequel le procédé de décodage est effectué de façon indépendante sur chacun du premier train binaire codé et du second train binaire codé pour produire ainsi une première forme d'onde reconstruite et une seconde forme d'onde reconstruite, chaque forme d'onde reconstruite étant représentative du signal audio ayant été codé.

**9.** Procédé suivant la revendication 7, dans lequel l'étape consistant à combiner les signaux reconstruits d'enveloppe en bande critique avec les formes d'ondes porteuses correspondantes consiste à moduler chacune des formes d'ondes porteuses avec les signaux d'enveloppe reconstruits correspondants en bande critique.

**10.** Procédé suivant la revendication 9, dans lequel chacune des formes d'ondes porteuses comprend une forme d'onde en cosinus ayant une fréquence fixe correspondante.

**11.** Procédé suivant la revendication 10, dans lequel la fréquence fixe de la forme d'onde porteuse correspondante est approximativement égale à une fréquence centrale du signal en bande à hautes fréquences qui lui correspond.

**12.** Procédé suivant la revendication 7, comprenant en outre l'étape consistant à combiner chacune des formes d'ondes reconstruites représentatives d'un signal correspondant en bande à hautes fréquences avec un signal de bruit correspondant.

**13.** Procédé suivant l'une quelconque des revendications précédentes, dans lequel le signal audio comprend un signal de parole.

**14.** Procédé suivant l'une quelconque des revendications 1 à 12, dans lequel le signal audio comprend un signal de musique.

**15.** Procédé suivant l'une quelconque des revendications précédentes, dans lequel les une ou plusieurs bandes de fréquences sont réparties de façon approximativement égale sur une échelle de Bark.

**16.** Procédé suivant l'une quelconque des revendications précédentes, dans lequel la fréquence seuil donnée est d'environ 1200 Hz.

**17.** Appareil comprenant des moyens conçus pour mettre en oeuvre les étapes d'un procédé suivant l'une quelconque des revendications précédentes.

FIG. 1

FIG. 2